(19) Europäisches Patentamt
European Patent Office
Office européen des brevets

(11) **EP 3 853 620 B1**

(12) **EUROPÄISCHE PATENTSCHRIFT**

(45) Veröffentlichungstag und Bekanntmachung des Hinweises auf die Patenterteilung:
**08.11.2023 Patentblatt 2023/45**

(21) Anmeldenummer: **19780175.6**

(22) Anmeldetag: **20.09.2019**

(51) Internationale Patentklassifikation (IPC):
**G01R 1/20** *(2006.01)*     **G01R 31/364** *(2019.01)*
**H01C 7/06** *(2006.01)*

(52) Gemeinsame Patentklassifikation (CPC):
**G01R 1/203; G01R 31/364; H01C 7/06;**
**H01M 10/48; H01M 50/569;** G01R 31/374;
H01M 2200/00; H01M 2220/20; Y02E 60/10

(86) Internationale Anmeldenummer:
**PCT/EP2019/075355**

(87) Internationale Veröffentlichungsnummer:
**WO 2020/058487 (26.03.2020 Gazette 2020/13)**

(54) **BATTERIESENSOR ZUR TEMPERATURUNABHÄNGIGEN STROMMESSUNG MIT EINEM SHUNT**

BATTERY SENSOR FOR TEMPERATURE-INDEPENDENT CURRENT MEASUREMENT USING A SHUNT

CAPTEUR DE BATTERIE PERMETTANT UNE MESURE DE COURANT INDEPENDANTE DE LA TEMPÉRATURE AU MOYEN D'UN SHUNT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **21.09.2018 DE 102018216184**

(43) Veröffentlichungstag der Anmeldung:
**28.07.2021 Patentblatt 2021/30**

(73) Patentinhaber: **Continental Automotive Technologies GmbH**
**30165 Hannover (DE)**

(72) Erfinder:
• **SCHRAMME, Martin**
**60488 Frankfurt am Main (DE)**
• **FRENZEL, Henryk**
**60488 Frankfurt am Main (DE)**
• **AUMER, Andreas**
**60488 Frankfurt am Main (DE)**

(74) Vertreter: **Continental Corporation**
**c/o Continental Teves AG & Co. OHG**
**Intellectual Property**
**Guerickestraße 7**
**60488 Frankfurt a. Main (DE)**

(56) Entgegenhaltungen:
**DE-A1- 10 000 500      DE-A1-102004 055 848**
**US-A1- 2011 057 764      US-A1- 2013 181 807**

**Beschreibung**

Die Erfindung betrifft einen Batteriesensor, insbesondere für eine Fahrzeugbatterie, mit zwei Anschlussteilen, die über ein Widerstandselement elektrisch leitend miteinander verbunden sind, wobei an den Anschlussteilen jeweils eine Kontaktstelle vorgesehen ist.

Batteriesensoren zur Bestimmung des Batteriezustands von Kraftfahrzeug-Batterien sind seit einiger Zeit auf dem Markt erhältlich. Gebräuchliche Batteriesensoren können in eine Anschlussklemme zum Anschließen eines Batteriekabels an einem Batteriepol integriert sein.

Solche Batteriesensoren enthalten üblicherweise Vorrichtungen zur Messung der Batteriespannung, des von der Batterie aufgenommenen oder abgegebenen Batteriestroms und einer in einem Bauteil des Batteriesensors gemessenen Temperatur. Der Batteriesensor beinhaltet üblicherweise auch einen Mikrocontroller, der diese Messdaten zwischenspeichert, filtert und daraus weitere Batteriegrößen, beispielsweise den Ladezustand, den Innenwiderstand oder eine bestimmte Zelltemperatur berechnet. Zu den weiteren typischen Batteriesensor-Funktionen gehören die Übertragung der gemessenen oder berechneten Daten an ein angeschlossenes Steuergerät des Kraftfahrzeugs, oftmals auch eine Eigendiagnose und ein entsprechender Fehlerspeicher, ferner ein Mode-Management zur Einstellung verschiedener Betriebsarten des Batteriesensors, die seine Funktionen und seinen Stromverbrauch an die jeweiligen Erfordernisse des Kraftfahrzeug-Bordnetzes anpassen.

Zur Messung der Rohdaten von Batteriespannung, Batteriestrom, und Temperatur stehen mehrere Analog-Digital-Wandler zur Verfügung, die zusammen mit dem Mikrocontroller und dessen Beschaltung auf einer Leiterplatte angeordnet sind, oder idealerweise in den Mikrocontroller integriert sein können. Die Strommessung erfolgt dabei gemäß des Ohmschen Gesetzes über das Shuntprinzip, das heißt, der zu messende Strom wird über einen geeigneten Widerstand, den sogenannten Shunt, in eine Spannung umgewandelt. Dafür enthält der Batteriesensor als weitere Schlüsselkomponente einen präzisen Messwiderstand (Shunt), welcher in den vom Batteriestrom durchflossenen Hauptstrompfad des Batteriesensors integriert ist. Die dem Batteriestrom proportionale Shuntspannung wird über eine entsprechende Beschaltung, die in der Regel einen Vorverstärker beinhaltet, einem Analog-Digital-Wandler zugeführt. Der Vorverstärker ist ggf. zusammen mit dem Microcontroller und/oder dem/den Analog-Digital-Wandler/n in einem integrierten Schaltkreis (ASIC) enthalten.

Ein wichtiges Merkmal der Widerstandslegierung ist ein geringer Temperaturkoeffizient, das heißt, die Änderung des Widerstands der Widerstandslegierung mit einer Änderung der Temperatur der Widerstandslegierung ist möglichst gering, zumindest deutlich geringer als der Temperaturkoeffizient des Anschlussteils.

Da es nun technisch nicht möglich ist, die Kontakte zum Abgreifen der Shuntspannung unmittelbar an die Schweißnähte zwischen der Widerstandslegierung und den Anschlussteilen zu platzieren, und es auch nicht vorteilhaft ist, die Kontakte auf der Widerstandslegierung zu platzieren, wird der Widerstand der Messtrecke insgesamt aus dem Widerstand der Widerstandslegierung und den Teilwiderständen der Anschlussteile innerhalb der Messstrecke gebildet. Da der Temperaturkoeffizient des elektrischen Widerstands der Anschlussteile deutlich höher als der Temperaturkoeffizient des Widerstands der Widerstandslegierung ist, ergibt sich in Summe ein Temperaturkoeffizient des Widerstands der Messstrecke, der vom Temperaturkoeffizienten des Widerstandsmaterial abweicht bzw. der größer ist als der Temperaturkoeffizient des Widerstandsmaterials.

Zur Bestimmung des elektrischen Widerstandes und somit des Batteriestroms ist also eine genaue Temperaturbestimmung erforderlich. Zur Bestimmung der Temperatur gibt es mehrere Möglichkeiten. Am einfachsten ist eine Temperaturmessung mit einem in den integrierten Schaltkreis enthaltenen Temperatursensor, der eine der Temperatur entsprechende Spannung erzeugt, die dann einem Analog-Digital-Wandler zugeführt wird. Genau genommen wird damit aber nicht die Temperatur der Batterie oder die Umgebungstemperatur der Batterie gemessen, sondern die Temperatur am Ort des Temperatursensors. Die Temperatur am gewünschten Ort muss dann mit Hilfe eines geeigneten Temperaturmodells aus der gemessenen Temperatur berechnet werden. Die Genauigkeit der berechneten Modelltemperatur leidet unter der schwer zu bestimmenden Eigenerwärmung des integrierten Schaltkreises, der Erwärmung des Batteriesensors durch den hindurchfließenden Batteriestrom und unterschiedliche thermische Dynamik der Batterie, ihrer Umgebung und einzelner Komponenten des Batteriesensors. Eine Verbesserung wird erreicht, indem ein zweiter Temperatursensor außerhalb des integrierten Schaltkreises auf der Leiterplatte platziert wird. Somit wird wenigstens der Temperatur-Messfehler durch eine Eigenerwärmung des integrierten Schaltkreises verringert.

In der US 2013/0181807A1 wird das Problem dadurch gelöst, dass durch seitliche Einschnitte in den Anschlusselementen der Stromfluss bzw. die Potentiallinien derart beeinfluss werden, dass der Einschluss des Widerstandes der Anschlusselemente reduziert wird. Auch in der US 2011/057764 werden die Kontaktpunkte der Anschlusselemente außerhalb des direkten Stromflusses angeordnet.

Aufgabe der Erfindung ist es, einen Batteriesensors bereitzustellen, der eine geringere Temperaturabhängigkeit aufweist.

Zur Lösung der Aufgabe ist ein Batteriesensor vorgesehen, insbesondere für eine Fahrzeugbatterie, mit zwei Anschlussteilen, die über ein Widerstandselement elektrisch leitend miteinander verbunden sind, wobei das Widerstandselement plattenförmig und im Wesentlichen rechteckig ausgebildet ist, wobei die Längsachse des Widerstandselements parallel zu einer Kante des Widerstandselements verläuft, wobei an den Anschlussteilen jeweils ein Kontaktpunkt vorgesehen ist, wobei die Richtung der Längsachse zumindest eines der Anschlussteile von der Richtung der Längsachse des Widerstandselements bzw. des Shunts abweicht. Die Position der Kontaktpunkte ist quer zur Längsachse des Widerstandselements bzw. des Shunts so gewählt, dass die elektrischen Widerstände von Abschnitten der Anschlussteile die vom Strom quer zur Längsachse des Widerstandselements bzw. des Shunts durchströmt werden so dimensioniert sind, dass eine temperaturbedingte Änderung der elektrischen Widerstände eine temperaturbedingte Änderung von elektrischen Widerständen, die aus Abschnitten der Anschlussteile, die in Richtung der Längsachse des Widerstandselements bzw. des Shunts durchströmt werden, gebildet sind, ausgleichen. Die Kontaktpunkte sind quer zur Längsachse des Widerstandselements versetzt angeordnet.

In dem Anschlussteil, dessen Richtung der Längsachse von der Längsachse des Widerstandselements abweicht, verläuft der Strom nicht parallel zur Längsrichtung des Widerstandselement. Es lässt sich eine weitere Achse definieren, die parallel zur Richtung der Längsachse des Widerstandselements und durch eine Seitenfläche des Widerstandsmaterials verläuft, die als Referenzpunkt für einen minimalen Spannungsabfall in y-Richtung gewählt werden kann. Ein gedachter Referenzpunkt befindet sich auf dieser Achse.

Somit lässt sich der zu messende Strom in diesem Anschlussteil in zweidimensionaler vektorieller Betrachtung zerlegen in eine erste Komponente, die orthogonal zur Richtung der Längsachse des Widerstandselements verläuft, und eine weitere Komponente, die parallel zur Richtung der Längsachse des Widerstandselements verläuft.

Dabei sollen das Widerstandselements und die Anschlussteile im Bereich des Widerstandselements als Ebene zu betrachten sein, die von den beiden Komponenten dieses zweidimensionalen vektoriellen Stroms aufgespannt wird.

Die zur Achse des Widerstandsmaterials orthogonal verlaufende Komponente des Stromvektors kann als Verbindungsvektor zwischen dem Referenzpunk und dem bisher verwendeten Spannungsabgriffspunkt auf der Mittellinie des Widerstandselements angesehen werden bzw. als y-Komponente des Stroms.

Erfindungsgemäß kann nun aufgrund der y-Komponente des Stroms auf einem weiteren gedachten Kontaktpunkt, der sich auf der Verbindungslinie des Referenzpunktes und des Spannungsabgriffspunktes befindet, ein Spannungsabfall zwischen den Referenzpunkt und dem Kontaktpunkt gemessen werden.

Erfindungsgemäß wird nun, bei zuvor geeignet festgelegter Position des ersten Kontaktpunkts auf dem andere Anschlussteil, der zweite Kontaktpunkt so gewählt, dass die Temperaturabhängigkeit des Quotienten U/I der über die Messstrecke zwischen den Kontaktpunkten gemessenen Spannung minimal wird. (Bei einem bekannten Kalibrierstrom I).

Die erfindungsgemäße Anordnung kann als Ersatzschaltbild beschrieben werden, bei dem das Widerstandsmaterial als in zwei entlang der Mittelachse voneinander getrennte Widerstände geteilt ist. Diese Widerstände bestehen aus der Widerstandslegierung mit minimalem Temperaturkoeffizienten des elektrischen Widerstands. Die Abstände der Punkte von der Verbindungsfläche des Widerstandsmaterials mit den Anschlussteilen bilden die Widerstände in Richtung der Längsachse des Widerstandselements über die Strecke des Materials der Anschlussteile. Diese weisen einen hohen Temperaturkoeffizienten des elektrischen Widerstands auf. Durch die Abstände der Kontaktstellen, des Spannungsabgriffspunkts sowie des Referenzpunkts quer zur Längsachse des Widerstandselements, die sich durch die Abstände paralleler Achsen durch die Kontaktstellen, den Spannungsabgriffspunkt sowie den definieren lassen, sind Abschnitte gebildet, die quer zur Längsachse des Widerstandselements vom Strom durchflossen sind. Sie bestehen ebenfalls aus dem Material der Anschlussteile und haben den gleichen Temperaturkoeffizienten des elektrischen Widerstands wie die Widerstände in Längsrichtung des Widerstandselements.

Beim Einspeisen eines Stroms in die Schaltung beim Referenzpunkt wird eine Gesamtspannung zwischen dem Referenzpunkt und dem ersten Kontaktpunkt erzeugt. Gemessen wird aber nicht diese Spannung, sondern die Spannung zwischen dem ersten Kontaktpunkt und dem zweiten Kontaktpunkt. Gemäß der Spannungsteilerregel entspricht diese Spannung der zwischen dem Referenzpunkt und dem ersten Kontaktpunkt angelegt Gesamtspannung multipliziert mit dem Quotienten aus den Widerständen der beiden virtuellen Teilwiderstände.

Durch geschickte Wahl des Teilerverhältnisses erhält man (für temperaturunabhängige Widerstände des Widerstandselements) einen temperaturabhängigen Spannungsteiler, dessen Temperaturabhängigkeit die Temperaturabhängigkeit der Gesamtspannung kompensiert.

Im realen System lässt sich somit die Temperaturabhängigkeit der Widerstände bis auf nichtlineare temperaturabhängige Widerstandsanteile der Widerstandslegierung kompensieren.

Bezogen auf eine Mittelachse des Widerstandselements kann sich zumindest ein Anschlussteil, dessen Richtung der Längsachse von der Richtung der Längsachse des Widerstandselements bzw. des Shunts abweicht, auf einer ersten Seite und der Kontaktpunkt dieses Anschlussteils bezogen auf eine Mittelachse auf der zweiten Seite befindet.

Bezogen auf eine Mittelachse des Widerstandselements kann sich zumindest ein Anschlussteil, dessen Richtung der Längsachse von der Richtung der Längsachse des Widerstandselements bzw. des Shunts abweicht, auf einer ersten Seite und der Kontaktpunkt dieses Anschlussteil bezogen auf eine Richtung quer zur Längsachse des Widerstandselements weiter von diesem Anschlussteil entfernt sein als der Kontaktpunkt des anderen Anschlussteils.

Die Kontaktpunkte weisen vorzugsweise im Wesentlichen den gleichen Abstand zum Widerstandelements.

Die Richtung der Längsachse zumindest eines der Anschlussteile weicht vorzugsweise derart von der Richtung der Längsachse des Widerstandselements bzw. des Shunts abweicht, dass die Richtung des durch diesem Anschlussteil fließenden Stroms nicht parallel zur Längsrichtung des Widerstandselement ist.

Vorzugsweise ist eine Spannungserfassungseinrichtung vorgesehen, die die Spannungen an den Kontaktpunkten erfasst, sowie eine Auswerteeinrichtung, die an den an den Kontaktpunkten erfassten Spannungen den über das Widerstandselement fließenden Strom ermittelt.

Weitere Vorteile und Merkmale ergeben sich aus der nachfolgenden Beschreibung in Verbindung mit den beigefügten Zeichnungen. In diesen zeigen:

Figur 1    eine Schematische Darstellung eines Batteriesensors aus dem Stand der Technik;

Figur 2    eine Darstellung eines erfindungsgemäßen Batteriesensors;

Figur 3    eine Detaildarstellung des Batteriesensor aus Figur 2; und

Figur 4    eine grafische Darstellung des temperaturabhängigen Spannungsverlaufes zwischen verschiedenen Kontaktstellen des Batteriesensors.

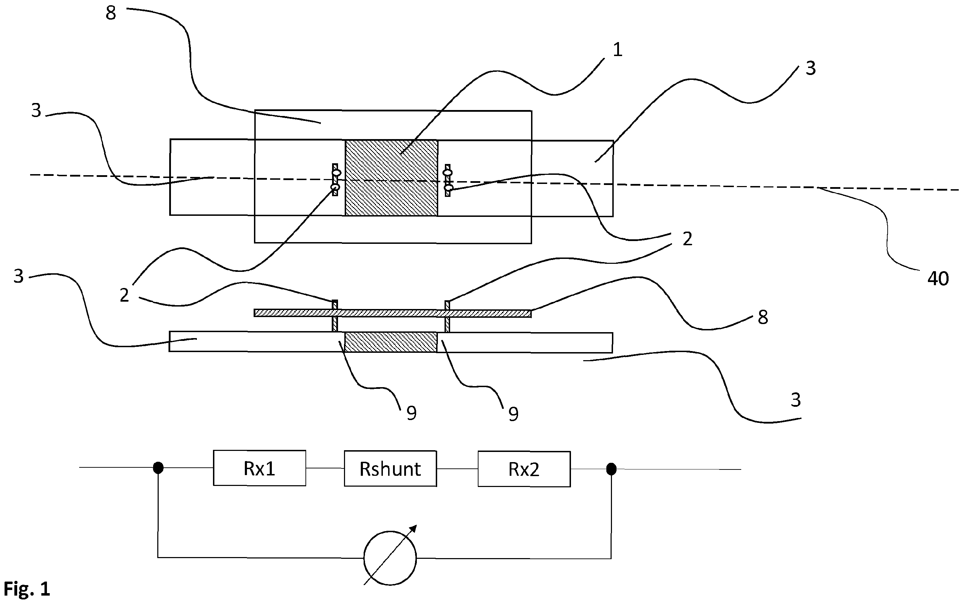

In Figur 1 ist schematisch ein herkömmlicher Batteriesensor gezeigt. Die Messung des Batteriestroms erfolgt nach dem Shuntprinzip, wobei gemäß des Ohmschen Gesetzes der durch den zu messenden Strom verursachte Spannungsabfall am Shuntwiderstand gemessen wird und der gemessene Spannungsabfall anhand von Kalibrierparametern, die letztlich den Widerstandswert des Shunts am jeweiligen Arbeitspunkt repräsentieren, in einen Stromwert umgerechnet wird. Kernstück des Shunts ist eine Messstrecke, die durch Abgriffspunkte (2) für die zu messende Shuntspannung begrenzt wird, und die in der Regel eine spezielle Widerstandslegierung (1) beinhaltet. Die Widerstandslegierung (1) ist an zwei in Stromrichtung gesehen gegenüberliegenden Seiten mit Anschlussteilen (3) fest verbunden, z. B. verschweißt. Die Anschlussteile dienen dem Anschließen des Shunts an den zu messenden Stromkreis. Das eine Anschlussteil ist daher beispielsweise als Adapter (30) zum Anschließen (schrauben, crimpen, löten, ...) eines Stromkabels oder einer sonstigen elektrischen Leitung ausgebildet oder mit einem derartigen Adapter verbindbar. Das andere Anschlussteil ist beispielsweise mit einer Polklemme (20) zum Anschließen an einen Batteriepol verbindbar oder im weiteren Verlauf selbst als Polklemme (20) ausgebildet. Somit bildet der Shunt inklusive der Anschlussteile einen Teil des Stromkreises, durch den der zu messende Strom fließt. Die beiden Anschlussteile sind zudem jeweils mit mindestens einem Kontakt zum Abgreifen der Shuntspannung über der Messtrecke versehen. Idealerweise befinden sich die Kontakte jeweils auf den Anschlussteilen in der Nähe der Verbindungslinie zwischen der Widerstandslegierung (1) und dem jeweiligen anschlussteil, z. B. in einer Entfernung von 1mm von der Schweißnaht zwischen Widerstandslegierung (1) und dem Anschlussteil. Ein wichtiges Merkmal der Widerstandslegierung (1) ist ein geringer Temperaturkoeffizient, d. h. die Änderung des Widerstands der Widerstandslegierung (1) mit einer Änderung der Temperatur der Widerstandslegierung (1) ist möglichst gering, zumindest deutlich geringer als der Temperaturkoeffizient des Anschlussteils.

Da es nun technisch nicht möglich ist, die Kontakte (2) zum Abgreifen der Shuntspannung unmittelbar an die Schweißnähte zwischen der Widerstandslegierung (1) und den Anschlussteilen (3) zu platzieren, und es auch nicht vorteilhaft ist, die Kontakte auf der Widerstandslegierung (1) zu platzieren, wird der Widerstand der Messtrecke insgesamt aus dem Widerstand der Widerstandslegierung (1) und den Teilwiderständen (Rx1, Rx2) der Anschlusteile (3) innerhalb der Messtrecke gebildet. Da der Temperaturkoeffizient des elektrischen Widerstands der Anschlussteile (3) deutlich höher als der Temperaturkoeffizient des Widerstands der Widerstandslegierung (1) ist, ergibt sich in Summe ein Temperaturkoeffizient des Widerstands der Messtrecke, der vom Temperaturkoeffizienten des Widerstandsmaterial abweicht bzw. der größer ist als der Temperaturkoeffizient des Widerstandsmaterials.

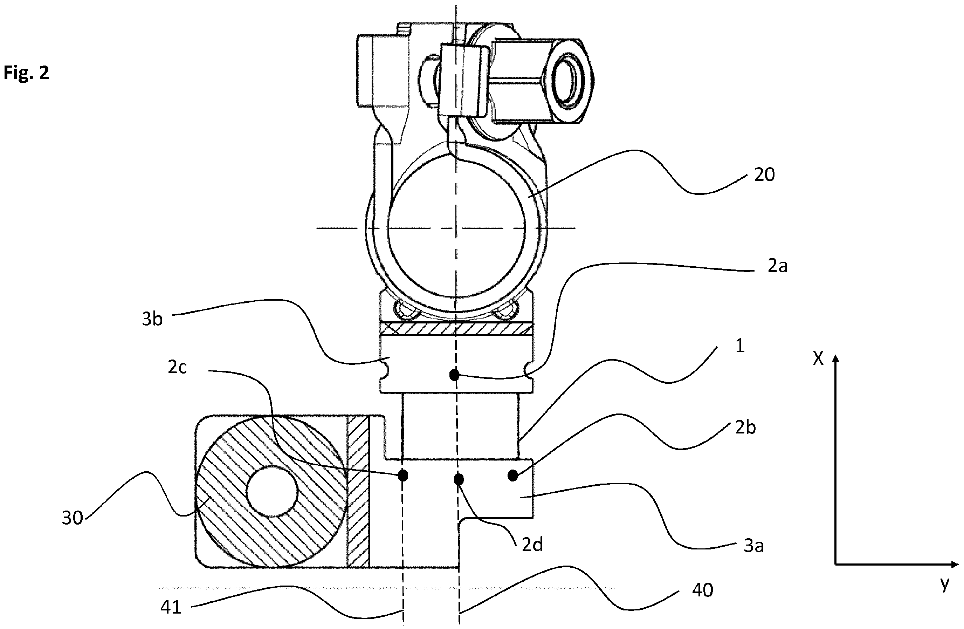

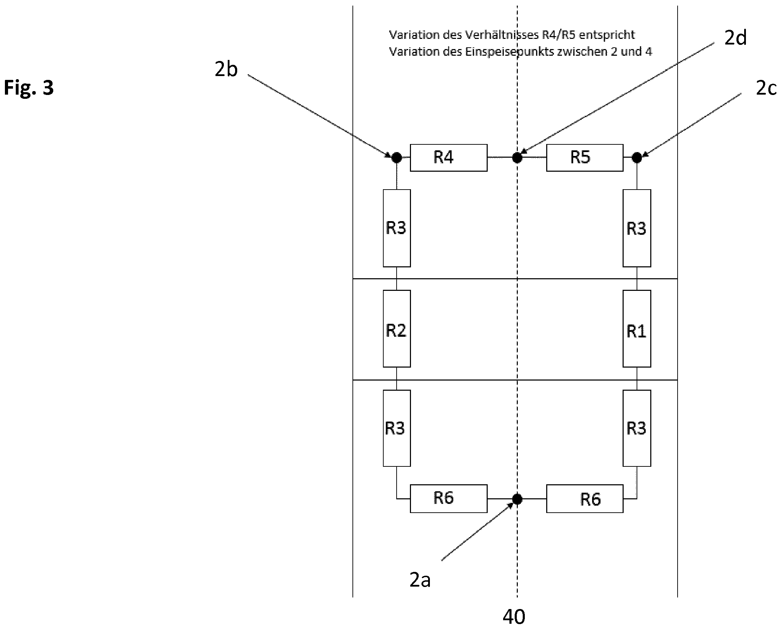

In den Figuren 2 und 3 wird nachfolgend wird ein Batteriesensor beschrieben, bei dem die Temperaturkoeffizienten der Messtrecke minimiert werden.

Eine erfindungsgemäße Strommessung wird für den Einsatz in Batteriesensoren zur nachgelagerten Berechnung von physikalischen Größen der Batterie vorgesehen. Dadurch kann der erfindungsgemäße Stromsensor auch alle bekannten weiteren Merkmale von Batteriesensoren aufweisen, insbesondere können eine oder mehrere Vorrichtungen zur Messung weiterer Spannungen, Temperaturen oder weiterer Größen der Batterie oder eines Kraftfahrzeugs in dem Stromsensor integriert sein.

Der erfindungsgemäße Stromsensor kann aber auch für beliebige andere Anwendungen genutzt werden, zum Beispiel Stromzähler zur Messung des Stromverbrauchs in Stromnetzwerken, Stromüberwachungssystemen, etc. in dem Stromsensor integriert sein.

Der erfindungsgemäße Stromsensor kann aber auch für beliebige andere Anwendungen genutzt werden, zum Beispiel Stromzähler zur Messung des Stromverbrauchs in Stromnetzwerken, Stromüberwachungssystemen, ... etc.

Bisher wird die Temperaturabhängigkeit des Widerstands der Messstrecke ermittelt, beispielsweise durch Messung des Temperaturverlaufs des elektrischen Widerstands an Mustern. Aus diesen Messwerten wird entweder ein Temperaturkoeffizient der Messstrecke für einen bestimmten Temperaturbereich ermittelt, oder es wird daraus eine Kennlinie für den elektrischen Widerstand der Messstrecke bei verschiedenen Temperaturen erzeugt. Die Ermittlung der Kennlinie bzw. der Temperaturkoeffizienten für bestimmte Temperaturbereiche erfolgt in der Regel einmalig während der Entwicklung des jeweiligen Sensortyps und wird in einem Speicher im Microcontroller des Sensors hinterlegt.

Während des Sensorbetriebs wird die Temperatur gemessen und anhand der hinterlegten Kennlinie oder des hinterlegten Temperaturkoeffizienten wird ein Korrekturwert für den Shuntwiderstand bei der gemessenen Temperatur berechnet.

Dieser Korrekturwert wird bei der Berechnung des Stromwerts aus der gemessenen Shuntspannung mit berücksichtigt.

Es wäre auch denkbar, die Kennlinie oder Temperaturkoeffizienten für bestimmte Temperaturbereiche im Rahmen einer Einzelteilkalibrierung für jeden einzelnen produzierten Sensor individuell zu bestimmen und im Speicher des jeweiligen Sensors zu hinterlegen. Dieser Methode steht jedoch der damit verbundene immense Aufwand entgegen.

Weiterhin sind Stromsensoren gemäß Stand der Technik so aufgebaut, dass der Stromfluss im Bereich der Messstrecke (1) und der Anschlussteile (3) im Wesentlichen parallel zu einer Achse (40) der Messstrecke fließt.

Der Stromsensor in den Figuren 2 und 3 ist so konstruiert, dass der zu messende Strom in mindestens einem Anschlussteil (3a) nicht parallel ("parallel" soll hier auch gleichbedeutend mit "entgegengesetzt parallel" verstanden werden) zur Achse (40) des Widerstandsmaterials verläuft.

Die Kontaktpunkte (2a, 2b) sowie ein gedachter Referenzpunkt 2c befinden sich in ungefähr gleicher Entfernung (in x-Richtung) von den jeweiligen Verbindungslinien zwischen Widerstandsmaterial (1) und Anschlussteilen (3a, 3b).

Es lässt sich auf dem mindestens einen Anschlussteil (3a), in dem der Strom nicht parallel zur Achse (40) des Widerstandsmaterials verläuft, eine weitere Achse 41 definieren, die durch eine Seitenfläche des Widerstandsmaterials verläuft, die als Referenzpunkt für einen minimalen Spannungsabfall in y-Richtung gewählt werden kann. Der gedachte Referenzpunkt 2c befindet sich auf dieser Achse 41.

Somit lässt sich der zu messende Strom in diesem Anschlussteil (3a) in zweidimensionaler vektorieller Betrachtung zerlegen in eine erste Komponente, die orthogonal zur Achse (40) des Widerstandsmaterials verläuft, und eine weitere Komponente, die parallel zur Achse (40) verläuft.

Dabei sollen das Widerstandsmaterial und die Anschlussteile (3a, 3b) im Bereich des Widerstandsmaterials als Ebene zu betrachten sein, die von den beiden Komponenten dieses zweidimensionalen vektoriellen Stroms aufgespannt wird. Die zur Achse des Widerstandsmaterials orthogonal verlaufende Komponente des Stromvektors kann als Verbindungsvektor der zwei Punkte 2c, 2b in Fig. 2 betrachtet werden bzw. als y-Komponente des Stroms.

Erfindungsgemäß kann nun aufgrund der y-Komponente des Stroms auf einem weiteren gedachten Punkt 2d, der sich auf der Verbindungslinie 2c -> 2b befindet, ein Spannungsabfall zwischen den Punkten 2c und 2d gemessen werden.

Erfindungsgemäß wird nun, bei zuvor geeignet festgelegter Position des ersten Kontaktpunkts 2a, der zweite Kontaktpunkt (2b) so gewählt, dass die Temperaturabhängigkeit des Quotienten U/I der über die Messstrecke (2b -> 2a) gemessenen Spannung U minimal wird. (Bei einem bekannten Kalibrierstrom I).

Eine erfindungsgemäße Anordnung kann mit dem in Fig.3 abgebildeten Ersatzschaltbild beschrieben werden. Man stelle sich das Widerstandsmaterial als in zwei entlang der Achse 40 voneinander getrennte Widerstände R1, R2 geteilt vor. Die Widerstände R1, R2 bestehen aus der Widerstandslegierung mit minimalem Temperaturkoeffizienten des elektrischen Widerstands. Die Abstände der Punkte 2a, 2b, 2c, 2d von der Verbindungsfläche des Widerstandsmaterials mit den Anschlussteilen bilden die Widerstände R3 über die Strecke des Materials der Anschlussteile. Diese weisen einen hohen Temperaturkoeffizienten des elektrischen Widerstands auf. Die Widerstände R4, R5, R6 bilden die von der y-Komponente des Stroms durchflossene Strecke ab. Sie bestehen ebenfalls aus dem Material der Anschlussteile und haben den gleichen Temperaturkoeffizienten des elektrischen Widerstands wie die Widerstände R3.

Man erkennt, dass beim Einspeisen eines Stroms in die Schaltung beim Punkt 2c eine Spannung Utotal zwischen 2c und 2a erzeugt wird. Gemessen wird aber nicht diese Spannung, sondern es wird die Spannung zwischen 2a und 2b U(2a, 2b) gemessen. Gemäß Spannungsteilerregel gilt:

$$U(2a, 2b) = Utotal * (2R3+R2+R6)/(R4+R5+2R3+R2+R6).$$

Durch geschickte Wahl des Teilerverhältnisses erhält man (für temperaturunabhängige R1, R2) einen temperaturabhängigen Spannungsteiler, dessen Temperaturabhängigkeit die Temperaturabhängigkeit der Gesamtspannung Utotal kompensiert.

Im realen System lässt sich somit die Temperaturabhängigkeit der Widerstände bis auf nichtlineare Temperaturabhängige Widerstandsanteile der Widerstandslegierung kompensieren.

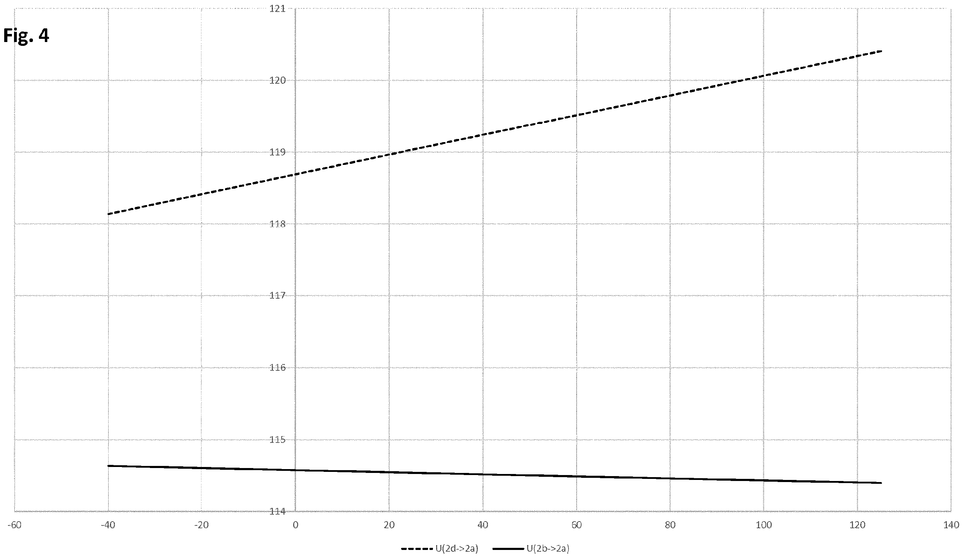

Fig. 4 zeigt eine Simulation des Temperaturverlaufs von U(2d->2a) und von U(2b->2a). Man erkennt, dass sich durch geeignete Wahl der Kontaktpunkte der Temperaturverlauf mit der Kompensationsmethode sogar umkehren lässt.

Der Einfluss der Temperaturdrift der elektrischen Widerstände auf die Strommessung kann ohne Temperaturmessung und ohne Berechnung eliminiert werden. Damit werden beispielsweise Fehler der Temperaturbestimmung des Shunts eliminiert. Wie eingangs erwähnt, erfolgt die Temperaturmessung im Batteriesensor in der Regel mit einem Temperatursensor, der auf der Leiterplatte angeordnet ist und somit in einiger Entfernung vom Shunt platziert ist. Somit ist der Temperatursensor der Erwärmung der elektrischen Bauteile auf der Leiterplatte stärker ausgesetzt als der Shunt. Umgekehrt ist der Temperatursensor thermisch nicht ausreichend an den Shunt gekoppelt, um eine dynamische Temperaturänderung des Shunts in Echtzeit zu erkennen. Beispielsweise kann sich der Shunt bei hohen Strömen innerhalb weniger Zehntelsekunden um über 100° erwärmen, wobei der Temperatursensor erst nach einigen Sekunden reagiert und eine weit geringere Erwärmung erkennt. Somit würde eine rechnerische Korrektur der Widerstandsdrift zu spät und zu gering erfolgen, womit die Strom-Messgenauigkeit beeinträchtigt wird.

Mit der vorliegenden Erfindung ist der Kompensationsmechanismus praktisch ein Teil des driftenden Systems und kann in Echtzeit und vollständig wirken. Zudem kann Rechenzeit und Speicherkapazität auf dem Microcontroller gespart werden.

Die Widerstände R3, R4, R5 und R6 sind also temperaturabhängig. Die Widerstände R1 und R2 sind dagegen weitgehend temperaturunabhängig bzw. weisen eine wesentlich geringere Temperaturabhängigkeit auf als die Widerstände R3, R4, R5, R6.

Der Kontaktpunkt 2b wird gemäß der Erfindung so gewählt, dass eine temperaturabhängige Änderung des elektrischen Widerstandes der Widerstände R4, R5, R6 eine temperaturbedingte Änderung des elektrischen Widerstandes des Widerstandes R3 ganz oder teilweise kompensiert.

Hierzu wird insbesondere die Position des Punktes 2b in Y Richtung also quer zur Längsrichtung bzw. zur Stromrichtung des Shunts so gewählt, dass eine temperaturabhängige Änderung des elektrischen Widerstandes der Widerstände R4, R5, R6 eine temperaturbedingte Änderung des elektrischen Widerstandes des Widerstandes R3 ganz oder teilweise kompensiert.

## Patentansprüche

1. Batteriesensor, insbesondere für eine Fahrzeugbatterie, mit zwei Anschlussteilen (3a, 3b), die über ein Widerstandselement (1) elektrisch leitend miteinander verbunden sind, wobei das Widerstandselement plattenförmig und im Wesentlichen rechteckig ausgebildet ist, wobei die Längsachse des Widerstandselements parallel zu einer Kante des Widerstandselements verläuft, wobei an den Anschlussteilen (3a, 3b) jeweils einen Kontaktpunkt (2a, 2b) vorgesehen ist, wobei die Richtung der Längsachse zumindest eines der Anschlussteile (3a, 3b) von der Richtung der Längsachse des Widerstandselements (1) abweicht, **dadurch gekennzeichnet, dass** die Position der Kontaktpunkte (2a, 2b) quer zur Längsachse des Widerstandselements so gewählt ist, dass die elektrischen Widerstände (R4, R5, R6) von Abschnitten der Anschlussteile (3a, 3b) die vom Strom quer zur Längsachse (y-Richtung) des Widerstandselements durchströmt werden so dimensioniert sind, dass eine temperaturbedingte Änderung der elektrischen Widerstände (R4, R5, R6) eine temperaturbedingte Änderung von elektrischen Widerständen (R3), die aus Abschnitten der Anschlussteile (3a, 3b), die in Richtung der Längsachse des Widerstandselements durchströmt werden, gebildet sind, ausgleichen, dass die Kontaktpunkte (2a, 2b) quer zur Längsachse des Widerstandselements versetzt angeordnet sind.

2. Batteriesensor nach einem der Ansprüche 1 und 2, **dadurch gekennzeichnet, dass** sich bezogen auf eine Mittelachse des Widerstandselements zumindest ein Anschlussteil, dessen Richtung der Längsachse von der Richtung der Längsachse des Widerstandselements (1) abweicht, auf einer ersten Seite und der Kontaktpunkt (2b) dieses Anschlussteils bezogen auf eine Mittelachse auf der zweiten Seite befindet.

3. Batteriesensor nach einem der vorhergehenden Ansprüche, **dadurch gekennzeichnet, dass** sich bezogen auf eine Mittelachse des Widerstandselements zumindest ein Anschlussteil, dessen Richtung der Längsachse von der Richtung der Längsachse des Widerstandselements (1) abweicht, auf einer ersten Seite und der Kontaktpunkt dieses Anschlussteil bezogen auf eine Richtung quer zur Längsachse des Widerstandselements weiter von diesem Anschlussteil entfernt ist als der Kontaktpunkt des anderen Anschlussteils.

4. Batteriesensor nach einem der vorhergehenden Ansprüche, **dadurch gekennzeichnet, dass** die Kontaktpunkte im Wesentlichen den gleichen Abstand zum Widerstandselements aufweisen.

5. Batteriesensor nach einem der vorhergehenden Ansprüche, **dadurch gekennzeichnet, dass** die Richtung der Längsachse zumindest eines der Anschlussteile (3a, 3b) derart von der Richtung der Längsachse des Widerstandselements (1) abweicht, dass die Richtung des durch diesem Anschlussteil fließenden Stroms nicht parallel zur Längsrichtung des Widerstandselement ist.

6. Batteriesensor nach einem der vorhergehenden Ansprüche, **dadurch gekennzeichnet, dass** eine Spannungserfassungseinrichtung vorgesehen ist, die die Spannungen an den Kontaktpunkten (2a, 2b) erfasst, sowie eine Auswerteeinrichtung, die an den an den Kontaktpunkten erfassten Spannungen den über das Widerstandelement fließenden Strom ermittelt.

**Claims**

1. Battery sensor, in particular for a vehicle battery, having two connection parts (3a, 3b) which are electrically conductively connected to one another via a resistor element (1), wherein the resistor element has a plate-shaped and substantially rectangular design, wherein the longitudinal axis of the resistor element runs parallel to an edge of the resistor element, wherein a contact point (2a, 2b) is provided on each of the connection parts (3a, 3b), wherein the direction of the longitudinal axis of at least one of the connection parts (3a, 3b) differs from the direction of the longitudinal axis of the resistor element (1), **characterized in that** the position of the contact points (2a, 2b) transverse to the longitudinal axis of the resistor element is selected such that the electrical resistors (R4, R5, R6) of sections of the connection parts (3a, 3b) through which current flows transverse to the longitudinal axis (y-direction) of the resistor element are dimensioned such that a temperature-related change in the electrical resistors (R4, R5, R6) compensates for a temperature-related change in electrical resistors (R3) which are formed from sections of the connection parts (3a, 3b) through which current flows in the direction of the longitudinal axis of the resistor element, **in that** the contact points (2a, 2b) are arranged offset transverse to the longitudinal axis of the resistor element.

2. Battery sensor according to either of Claims 1 and 2, **characterized in that**, in relation to a centre axis of the resistor element, at least one connection part, the direction of the longitudinal axis of which differs from the direction of the longitudinal axis of the resistor element (1), is situated on a first side and the contact point (2b) of this connection part is situated on the second side in relation to a centre axis.

3. Battery sensor according to either of the preceding claims, **characterized in that**, in relation to a centre axis of the resistor element, at least one connection part, the direction of the longitudinal axis of which differs from the direction of the longitudinal axis of the resistor element (1), is further away on a first side and the contact point of this connection part, in relation to a direction transverse to the longitudinal axis of the resistor element, is further away from this connection part than the contact point of the other connection part.

4. Battery sensor according to one of the preceding claims, **characterized in that** the contact points are at substantially the same distance from the resistor element.

5. Battery sensor according to one of the preceding claims, **characterized in that** the direction of the longitudinal axis of at least one of the connection parts (3a, 3b) differs from the direction of the longitudinal axis of the resistor element (1) in such a way that the direction of the current flowing through this connection part is not parallel to the longitudinal direction of the resistor element.

6. Battery sensor according to one of the preceding claims, **characterized in that** provision is made for a voltage detection device which detects the voltages at the contact points (2a, 2b), and an evaluation device which ascertains the current flowing through the resistor element at the voltages detected at the contact points.

**Revendications**

1. Capteur de batterie, en particulier pour une batterie de véhicule, comprenant deux parties de raccordement (3a, 3b) qui sont reliées ensemble de manière électriquement conductrice par un élément de résistance (1), l'élément de résistance étant réalisé en forme de plaque et de manière substantiellement rectangulaire, dans lequel l'axe longitudinal de l'élément de résistance s'étend en parallèle à un bord de l'élément de résistance, dans lequel respectivement un point de contact (2a, 2b) est prévu au niveau des parties de raccordement (3a, 3b), dans lequel la direction de l'axe longitudinal au moins d'une des parties de raccordement (3a, 3b) diverge de la direction de l'axe longitudinal de l'élément de résistance (1),

**caractérisé en ce que** la position des points de contact (2a, 2b) transversalement à l'axe longitudinal de l'élément de résistance est choisie de telle sorte que les résistances électriques (R4, R5, R6) de sections des parties de raccordement (3a, 3b) traversées par le courant transversalement à l'axe longitudinal (direction y) de l'élément de résistance sont dimensionnées de telle sorte qu'une variation, due à la température, des résistances électriques (R4, R5, R6) compense une variation, due à la température, des résistances électriques (R3) qui sont formées par des sections des parties de raccordement (3a, 3b) qui sont traversées en direction de l'axe longitudinal de l'élément de résistance, de sorte que les points de contact (2a, 2b) sont disposés de manière décalée transversalement à l'axe longitudinal de l'élément de résistance.

2. Capteur de batterie selon l'une quelconque des revendications 1 et 2, **caractérisé en ce que** par rapport à un axe médian de l'élément de résistance, au moins une partie de raccordement dont la direction de l'axe longitudinal diverge de la direction de l'axe longitudinal de l'élément de résistance (1) se trouve sur un premier côté, et le point de contact (2b) de cette partie de raccordement se trouve sur le deuxième côté par rapport à un axe médian.

3. Capteur de batterie selon l'une quelconque des revendications précédentes, **caractérisé en ce que** par rapport à un axe médian de l'élément de résistance, au moins une partie de raccordement dont la direction de l'axe longitudinal diverge de la direction de l'axe longitudinal de l'élément de résistance (1), est plus éloignée sur un premier côté, et le point de contact de cette partie de raccordement par rapport à une direction transversale à l'axe longitudinal de l'élément de résistance est plus éloigné de cette partie de raccordement que le point de contact de l'autre partie de raccordement.

4. Capteur de batterie selon l'une quelconque des revendications précédentes, **caractérisé en ce que** les points de contact présentent substantiellement la même distance par rapport à l'élément de résistance.

5. Capteur de batterie selon l'une quelconque des revendications précédentes, **caractérisé en ce que** la direction de l'axe longitudinal au moins d'une des parties de raccordement (3a, 3b) diverge de la direction de l'axe longitudinal de l'élément de résistance (1) de telle sorte que la direction du courant circulant par cette partie de raccordement n'est pas parallèle à la direction longitudinale de l'élément de résistance.

6. Capteur de batterie selon l'une quelconque des revendications précédentes, **caractérisé en ce qu'**un dispositif de détection de tension est prévu qui détecte les tensions au niveau des points de contact (2a, 2b), et un dispositif d'évaluation est prévu qui détermine le courant circulant par l'élément de résistance aux tensions détectées aux points de contact.

**Fig. 1**

Fig. 2

EP 3 853 620 B1

20

2a

3b

2c

1

2b

30

2d

3a

41

40

X

y

EP 3 853 620 B1

**Fig. 3**

Variation des Verhältnisses R4/R5 entspricht
Variation des Einspeisepunkts zwischen 2 und 4

2b

2d

2c

2a

40

Fig. 4

U(2d->2a)        U(2b->2a)

EP 3 853 620 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20130181807 A1

- US 2011057764 A